(19) **Europäisches Patentamt**
**European Patent Office**
**Office européen des brevets**

(11) **EP 2 059 955 B1**

(12) **EUROPÄISCHE PATENTSCHRIFT**

(45) Veröffentlichungstag und Bekanntmachung des Hinweises auf die Patenterteilung:
**28.04.2010 Patentblatt 2010/17**

(21) Anmeldenummer: **07802736.4**

(22) Anmeldetag: **20.08.2007**

(51) Int Cl.:
*H01L 39/12* (2006.01)     *H01L 39/24* (2006.01)

(86) Internationale Anmeldenummer:
**PCT/EP2007/058640**

(87) Internationale Veröffentlichungsnummer:
**WO 2008/025697 (06.03.2008 Gazette 2008/10)**

(54) **HOCHTEMPERATUR-SCHICHTSUPRALEITERAUFBAU UND VERFAHREN ZU SEINER HERSTELLUNG**

HIGH-TEMPERATURE LAYER SUPRACONDUCTOR STRUCTURE AND METHOD FOR THE MANUFACTURE THEREOF

STRUCTURE SUPRACONDUCTRICE STRATIFIÉE DE TEMPÉRATURE ÉLEVÉE ET PROCÉDÉ POUR SA FABRICATION

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **29.08.2006 DE 102006041513**

(43) Veröffentlichungstag der Anmeldung:
**20.05.2009 Patentblatt 2009/21**

(73) Patentinhaber: **evico GmbH**
**01069 Dresden (DE)**

(72) Erfinder: **ENGEL, Sebastian**
**88316 Isny (DE)**

(74) Vertreter: **Rauschenbach, Marion**
**Rauschenbach Patentanwälte,**
**Bienertstrasse 15**
**01187 Dresden (DE)**

(56) Entgegenhaltungen:
**EP-A- 1 178 129     WO-A-2005/121414**
**WO-A-2006/071543**

- **RUPICH M W ET AL: "Progress on MOD/ RABiTS<TM> 2G HTS wire" PHYSICA C, NORTH-HOLLAND PUBLISHING, AMSTERDAM, NL, Bd. 412-414, Oktober 2004 (2004-10), Seiten 877-884, XP004579522 ISSN: 0921-4534**
- **CHANG SU KIM ET AL: "Study of the growth of biaxially textured CeO2 films during ion-beam-assisted deposition; Study of the growth of biaxially textured CeO2 films during ion-beam-assisted deposition" SUPERCONDUCTOR SCIENCE & TECHNOLOGY, INSTITUTE OF PHYSICS PUBLISHING, BRISTOL, GB, Bd. 18, Nr. 3, 1. März 2005 (2005-03-01), Seiten 330-333, XP020088122 ISSN: 0953-2048**

**EP 2 059 955 B1**

**Beschreibung**

Die Erfindung bezieht sich auf das Gebiet der Materialwissenschaften und der Hochtemperatursupraleitertechnik und betrifft einen Hochtemperatur-Schichtsupraleiteraufbau, wie er beispielsweise in Vorrichtungen zum Transport, zur Speicherung oder zur Umwandlung von elektrischer Energie angewendet werden kann und ein Verfahren zu seiner Herstellung.

Beschichtungen aus Hochtemperatursupraleitern werden häufig für die Anwendungen in der Energietechnik eingesetzt. Das Verschwinden des elektrischen Widerstandes unterhalb der Sprungtemperatur ermöglicht eine Erhöhung des Wirkungsgrades der verschiedensten Vorrichtungen, als auch kompaktere Konstruktionen.

Derartige Schichtaufbauten bestehen üblicherweise aus einem Trägermaterial, welches in vielen Fällen ein dünnes Metallband mit einer darauf aufgebrachten Schicht aus nichtleitendem oder auch leitendem Material ist oder es ist ein Träger aus einem nichtleitenden Material, wie beispielsweise Keramik. Darauf befindet sich dann die hochtemperatursupraleitende Schicht. Derartige sogenannte Bandleiter können in etablierten Anwendungen Kupferleitungen ersetzen, die mit hohen Strömen belastet sind. Die bei Kupferleitungen vorhandenen hohen Verluste können durch den Einsatz dieser Bandleiter deutlich verringert werden und hohe Stromdichten werden realisierbar.

Für technische Anwendungen ist nach wie vor die Stromtragfähigkeit eines Supraleiters von großer Bedeutung. Untersuchungen haben gezeigt, dass zur Erhaltung der Stromtragfähigkeit von Supraleiterschichten entweder ein einkristallines oder texturiertes Substrat und eine epitaktisch gewachsene Pufferschicht zwischen Supraleiterschicht und Substrat vorhanden sein müssen. Dazu wird nach der DE 102 48 025 A1 ein polykristallines oder amorphes Substrat mit einer biaxial texturierten Pufferschicht mittels Beschichtung unter schräger Depositonsrichtung (ISD) versehen. Auf diese Pufferschicht wird dann die Supraleiterschicht, zumeist $RE\text{-}Ba_2Cu_3O_7$ oder $Y\,Ba_2Cu_3O\mu_7$ aufgebracht.

Pufferschichten dienen weiterhin auch dazu, das Eindiffundieren von Metallatomen des Trägermaterials in das supraleitende Material zu verhindern (Diffusionsbarriere). Gleichzeitig kann durch eine solche Pufferschicht die unkontrollierte Oxidation des metallischen Substratmaterials bei der Supraleiterbeschichtung und spezifischer Temperaturbehandlung in sauerstoffreicher Atmosphäre verhindert, die Gitterparameter der verschiedenen Materialien angepasst, die Oberfläche des zu beschichtenden Trägers geglättet, und die Haftung des supraleitenden Materials verbessert werden. Derartige Pufferschichten bestehen insbesondere aus $La_2Zr_2O_7$ [T.G. Chirayil u.a. Physica C 336 (2000) 63-69], $Gd_2O_3$ [M.P. Paranthaman, u.a., Physica C 378-381 (2002) 1009-1012], MgO [T. Horide, u.a., Physica C 412-414 (2004) 1291-1295], YSZ [US 2002/0178999

A1], $Y_2O_3$ [DE 199 32 444 C2], $CeO_2$ [S. Sathyamurthy u.a., J. Mater. Res. Vo. 19, No. 7, Jul 2004], $SrTiO_3$ [DE 10 2004 041 053 A1], $BaTiO_3$ [DE 10 2004 038 030 A1] und werden hier ausschließlich als Pufferschichtbestandteil in einem Pufferschichtsystem verwendet. Die Verwendung von kubischen Oxiden oder Mischoxiden, welche biaxial texturiert auf einem metallischen Substrat aufwachsen, ist Stand der Technik. Hierfür werden vorzugsweise die kubischen, pyrochloren Gitterstrukturen des $La_2Zr_2O_7$, kubische Perowskit - Strukturen des YSZ, $SrTiO_3$, $BaTiO_3$, oder kubische Gittertypen des $CeO_2$, $Gd_2O_3$ oder auch MgO verwendet, welche über verschiedene physikalische oder auch chemische Dünnschichttechnologien auf ein metallisches Substrat aufgebracht werden. Hierbei wird das Wachstum der genannten Oxide, durch die jeweilige Prozessführung und Dünnschichttechnologie dahingehend beeinflusst, dass die (001)-Ebenen der Einheitszellen genannter Oxide biaxial texturiert in [001]-Richtung wachsen. Ein Auswahlkriterium für die Nutzung der genannten, kubischen Oxide oder Mischoxide als Pufferschichten bzw. Pufferschichtsystem ist die geringe Fehlpassung der Gitterparameter zu den verwendeten metallischen Substraten. Als Substrat werden häufig (001) biaxial texturierte Ni-Bänder bzw. Ni-Basis Legierungen verwendet, wobei die (001)-Ebenen, der genannten kubischen Oxide, in [001]-Richtung aufwachsen und das kubische Gitter dieser Oxide im Bezug auf das kubische Substratgitter jeweils eine Gitterfehlpassung kleiner als 10 Prozent aufweist.

Weitere Anforderungen, wie hohe Pufferwirkung gegen Sauerstoff und Nickeldiffusion, als auch chemische Beständigkeit gegenüber YBCO werden zumeist nur über Puffer-Multilagen erreicht.

Nach dem bisherigen Stand der Technik ist es nicht möglich Eigenschaften wie guten Texturübertrag, ausreichende Puffer- bzw. Barrierewirkung und ein chemisch amphoteres Verhalten gegenüber hochtemperatur - supraleitender Schicht in einem Puffer zu vereinen.

Weiterhin bekannt ist eine Pufferschichtarchitektur für hochtemperatur - supraleitende Bandleiter, wie beispielsweise $YBa_2Cu_3O_7$-Bandleiter. Aus US 2002/0192508 A1 ist ein Supraleiteraufbau bekannt, bei dem ein metallisches Substrat verwendet wird, welches aus Cu, Ag, Mo, Cd, Co, Pd, Pt, Ni oder Ni-Basislegierungen besteht. Das Substrat kann hierbei biaxial texturiert oder polykristallin sein. Auf dem Substrat wird mittels verschiedener physikalischer Dünnschichttechniken, wie gepulste Laserdeposition, Aufdampfen etc., im Vacuum ein oxidisches Pufferschichtsystem abgeschieden, welche zum einen als Diffusionsbarriere, als auch als Texturvermittler für oxidische supraleitende Schichten dient.

In US 2002/0192508 A1 sind weiterhin die Vorteile einer Einzelpufferschicht bestehend aus kubischen (100) - $ZrO_2$ und $HfO_2$ beschrieben, welche auf einem metallischen Substrat (Ni) aufwachsen, um als Wachstumsvermittler für YBCO zu fungieren. Da es jedoch nach Aussage der Erfinder nicht möglich ist, die genannten Oxide direkt auf (*100*) - Ni biaxial orientiert zu deponieren, wird eine dünne Zwischenschicht aus vorzugsweise $CeO_2$ als Keimschicht verwendet, um den eigentlichen Puffer aus kubischem YSZ, $ZrO_2$ bzw. $HfO_2$ (100) orientiert aufwachsen lassen zu können.

Bekannt ist auch, dass die kubischen Phasen von Oxiden der Ti-Gruppe, wie $ZrO_2$ und $HfO_2$, durch Dotieren von Y, Ce, Ca, Sr, Ba, stabilisiert werden können. Hierbei können über die Zugabe so genannter Dotierstoffe Gitterparameter angepasst und entsprechend der gewählten Schichttechnologie die Textur des Substrates auf die oxidische Pufferschicht übertragen werden.

Weiterhin ist bekannt, dass die kubischen Perowskite mit der Struktur $ABO_3$, wobei A Ca, Sr oder Ba sein kann und B aus Zr oder Hf besteht (100) texturiert auf einem biaxial texturierten (100) - Nickel aufwachsen können. Vorzugsweise besteht die Pufferschicht nach US 2002/0192508 A1 aus dem kubischen YSZ (a = 5.126Å) (1Å=0,1nm).

Aufgabe der vorliegenden Erfindung ist es, einen Hochtemperatur-Schichtsupraleiteraufbau anzugeben, der eine Pufferschicht aufweist, die einen guten Texturübertrag, eine ausreichende Puffer- und Barrierewirkung und ein chemisch amphoteres Verhalten gegenüber hochtemperatursupraleitenden Schichten aufweist, sowie ein einfaches und kostengünstiges Verfahren zu seiner Herstellung.

Die Aufgabe wird durch die in den Ansprüchen angegebene Erfindung gelöst. Vorteilhafte Ausgestaltungen sind Gegenstand der Unteransprüche.

Der erfindungsgemäße Hochtemperatur-Schichtsupraleiteraufbau besteht aus einem biaxial texturierten Substrat, auf dem eine oder mehrere Pufferschichten angeordnet sind und einer oder mehreren darüber angeordneten Supraleiterschichten, wobei mindestens die direkt auf dem Substrat befindliche Pufferschicht mindestens überwiegend aus einem oder mehreren Oxiden mit einem nichtkubischen Kristallgitter besteht, wobei das nichtkubisches Kristallgitter mindestens eine quadratische oder quasiquadratische Netzebene aufweist, und diese quadratische oder quasiquadratische Netzebene von mindestens 90 % der nichtkubischen Kristallite der Oxide der Pufferschicht sich auf der dem Substrat zugewandten Seite der Pufferschicht befinden und die quadratischen oder quasiquadratischen Netzebenen der Kristallgitter der Pufferschicht mit einer quadratischen oder quasiquadratischen Netzebene der Kristallgitters des biaxial texturierten Substrates deckungsgleich übereinander oder diagonal zueinander angeordnet sind, wobei die Atomabstände (*a*) der Netzebene der Kristallgitter der Pufferschicht $a_{Pufferschicht}$ im Vergleich zu denen des

Substrats $a_{Substrat}$ die Bedingung

$$1 - \frac{a_{Substrat}}{a_{Pufferschicht} \cdot \frac{1}{\sqrt{2}}} \leq \pm 0,1 \quad \text{erfüllen.}$$

Vorteilhafterweise ist als biaxial texturiertes Substrat ein Band aus Nickel, Nickel-Wolfram Legierungen, Ni-Chrom Legierungen, Ni-Mangan Legierungen, Ni-Silber Legierung, Kupfer und seine Legierungen, eingesetzt, wobei besonders vorteilhafterweise ein (100)-orientiertes Nickelband eingesetzt ist.

Ebenfalls kommen vorteilhafterweise als Oxide mit einem nichtkubischen Kristallgitter für die Pufferschicht orthorhombische Perowskite, hexagonale oder tetragonale Kristallstrukturen der Oxide zum Einsatz.

Weiterhin vorteilhafterweise ist die quadratische oder quasiquadratische Netzebene die (00l)- und/oder die (h0l)- und/oder die (hk0)-Ebene des Kristallgitters der nichtkubischen Oxide, wobei besonders vorteilhafterweise Oxide mit einem orthorhombischen Kristallgitter und einer quadratischen oder quasiquadratischen (h0l)-Ebene die Pufferschicht auf dem Substrat bilden und in [001]-Richtung auf dem (100)-orientierten Substrat aufwachsen.

Vorteilhaft ist es auch, wenn der quasiquadratische Zustand um maximal 5 % vom quadratischen Zustand der Netzebene abweicht.

Weiterhin vorteilhaft ist es, wenn die direkt auf dem Substrat befindliche Pufferschicht zu 99,8 % aus einem oder mehreren Oxiden mit einem nichtkubischen Kristallgitter besteht, wobei deren quadratische oder quasiquadratische Netzebene zu 95 bis 100 % auf der Oberfläche angeordnet ist, die sich im direkten Kontakt mit der Substratoberfläche befindet.

Ebenfalls vorteilhaft ist es, wenn 95 % bis alle quadratischen oder quasiquadratischen Netzebenen der nichtkubischen Kristallgitter der Oxide der Pufferschicht deckungsgleich auf den quadratischen oder quasiquadratischen Netzebenen der Kristallgitter der Substratmaterialien angeordnet sind.

Bei dem erfindungsgemäßen Verfahren zur Herstellung eines Hochtemperatur-Schichtsupraleiteraufbaus werden auf ein biaxial texturiertes Substrat mindestens ein Oxidmaterial und ein oder mehrere Dotierungselemente gemeinsam ein oder mehrmals nacheinander als eine oder mehrere Pufferschichten aufgebracht und nachfolgend einer Temperaturerhöhung bis maximal 1400°C ausgesetzt, wobei mindestens die direkt auf dem Substrat befindliche Pufferschicht ein oder mehrere Oxidmaterialien enthält, wobei als Oxidmaterialien solche Oxide eingesetzt werden, welche in der Lage sind, nach der Temperaturerhöhung bis maximal 1400 °C eine kubische Kristallstruktur ausbilden, und wobei als Oxidmaterial Oxide gemäß der Strukturformel $(A_{1-x}B_x)CO_3$ mit $x \geq 0$, A = Ca, Sr, Ba, Mg, Mn, Mo, Nb, Ru, V, B = Ce, Nd, Sm, Gd, Dy und C= ein Element der IV. Nebengruppe des PSE eingesetzt werden, und wobei die Dotierungselemente die kubische Kristallstruktur des Oxidmaterials während der Temperaturerhöhung in eine nichtkubische Oxidkristallstruktur überführen, und danach mindestens eine supraleitende Schicht aufgebracht und der Schichtverbund wiederum einer Temperaturbehandlung unterzogen wird.

Vorteilhafterweise wird ein (100)-orientiertes Nickelband als Substrat eingesetzt.

Weiterhin vorteilhafterweise werden als Dotierungselemente zur Überführung einer kubischen in eine nichtkubische Oxidkristallstruktur Seltenerden-Elemente oder Mischungen davon eingesetzt.

Auch vorteilhafterweise wird als nichtkubische Oxidkristallstruktur eine orthorhombische Kristallstruktur hergestellt.

Von Vorteil ist es auch, wenn als quadratische oder quasiquadratische Netzebene die {h0l}-Ebenen des nichtkubischen Oxidkristalles eingestellt wird.

Weiterhin von Vorteil ist es, wenn auf ein Substrat mindestens eine Pufferschicht aufgebracht wird, die mittels Abscheidung aus der chemischen Lösung mit nachfolgender Temperaturbehandlung bei 600°C bis 1200°C in reduzierender Atmosphäre synthetisiert wird.

Auch vorteilhaft ist es, wenn als Oxidmaterial chemische Lösungen eingesetzt werden, welche die Elemente gemäß der Strukturformel $(A_{1-x}B_x)CO_3$ als Precursor-Substanz enthalten, wobei A = Ca, Sr, Ba, Mg, Mn, Mo, Nb, Ru, V und B = Ce, Nd, Sm, Gd, Dy und C= ein Element der IV. Nebengruppe des PSE sind, wobei vorteilhafterweise als Lösemittel Karbonsäuren eingesetzt werden, und vorteilhafterweise als Karbonsäuren Propionsäure, Essigsäure, oder Alkohole, sowie Mischungen davon eingesetzt werden, und vorteilhafterweise als Alkohole Methanol, Ethanol, Propanonol, sowie Mischungen davon eingesetzt werden.

Und auch vorteilhaft ist es, wenn als Precursoren metallorganische Verbindungen eingesetzt werden, wobei besonders vorteilhaft als metallorganische Verbindungen Azetate, Acetylacetonate, Nitrate, Propoxide, Ethoxide eingesetzt werden.

Ebenfalls von Vorteil ist es, wenn die Pufferschicht(en) durch Sputtern, gepulser Laserbeschichtung (PLD), Aufdampfen, Ionenstrahl unterstützter Beschichtungsmethoden, Beschichtung aus chemischen Gasphasenreaktionen, Beschichtung mittels Lösungsabscheidung aufgebracht werden.

Gegenstand der Erfindung ist ein Hochtemperatur-Supraleiterschichtaufbau auf einem biaxial texturierten Substrat mit mindestens einer Pufferschicht, bestehend aus nichtkubischen Oxiden, welche mindestens eine quadratische oder quasiquadratische Netzebene besitzen. Hierbei kann die Netzebene, oder auch Netzebenen-Schaar nicht zwingendermaßen die (00l)-Ebene sein, sondern kann erfindungsgemäß auch eine der (h0l)-Ebenen und/oder (hk0)-Ebenen sein.

Die nichtkubischen Oxide wachsen gemäß dem erfindungsgemäßen Herstellungsverfahren ausgehend von einer der quadratischen Netzebenen auf dem Substrat mit einer kubischen Einheitszelle (Würfeltextur) biaxial texturiert auf. Durch den Einsatz von einem oder mehreren Dotierungselementen zur Überführung einer kubischen in eine nichtkubische Oxidkristallstruktur des Oxidmaterials und der nachfolgenden Temperaturerhöhung wird das kubische Kristallgitter vorteilhafterweise in ein orthorhombisches Kristallgitter umgewandelt, welches aber mindestens noch eine quadratische oder quasiquadratische Netzebene aufweist.

Durch den erfindungsgemäßen Einsatz neuer Oxide in der Bandleiterentwicklung, wird hierdurch eine Möglichkeit geschaffen, Pufferschichten zu entwickeln, welche die positiven Eigenschaften eines dem Stand der Technik entsprechenden Pufferschichtsystems, bestehend aus mehreren Einzelpuffern, in einer Schicht vereinigen. Weiterhin wird durch die Wahl der Oxide, und gegebenenfalls Dotierung dieser, die Fehlpassung zum metallischen Substrat als auch zur supraleitenden Schicht bis ins Optimum minimiert. Als vorteilhaft haben sich Oxide mit einer orthorhombischen Gitterstruktur erwiesen, welche eine quadratische oder quasiquadratische (h0l)-Ebene haben.

Durch das erfindungsgemäße Verfahren entstehen während der Herstellung einer oxidischen Pufferschicht auf einem biaxial texturierten Substrat durch den Einsatz von Dotierungselementen Oxide mit einem vorteilhafterweise orthorhombischen Kristallgitter

Die erfindungsgemäße oxidische Pufferschicht der Strukturformel $(A_{1-x}B_x)CO_3$ zeichnet sich durch exzellente Puffereigenschaften wie hohe Texturschärfe, gute Sauerstoffbarriere und laterales Wachstum aus. Hierbei wird nicht wie in US 2002/0192508 A1 die kubische Gitterstruktur der kubischen Oxide, wie beispielsweise $HfO_2$, durch Dotierungselemente, wie Ca, Sr, Ba, oder Seltenerden-Elemente, stabilisiert, sondern die kubische Perowskit-Struktur des beispielsweise $CaHfO_3$ ($a$= 5.08A) ist durch Dotierstoffe, die zu einer Überführung eines kubischen Kristallgitters in ein nichtkubisches Kristallgitter mit mindestens einer quadratischen oder quasiquadratischen Netzebene fähig sind, in eine vorteilhafterweise orthorhombische Kristallstruktur überführt worden. Das orthorhombische Kristallgitter weist dabei die folgenden Werte auf (a=5.72Å, b= 7.82Å, c=5.57Å). Das Wachstum der oxidischen Pufferschicht auf beispielsweise einem (100)-Ni-Band erfolgt durch die Entstehung des orthorhombischen Kristallgitters in Form beispielsweise eines Perowskits, bevorzugt in der $(A_{1-x}B_x)CO_3$-(202)-Ebene.

Die Anpassung der Gitterparameter für ein biaxiales Wachstum der Pufferschicht auf dem jeweiligen metallischen Substrat wird über den Dotierungsgrad des orthorombischen Perowskit mit den Dotierungselementen gesteuert.

Dabei werden erfindungsgemäß als quadratische oder quasiquadratische Netzebenen die {h0l}-Ebenen des nichtkubischen Oxidkristalles eingestellt, die direkt in [001] - Richtung biaxial texturiert auf dem texturierten Substrat aufwachsen.

Weiterer Gegenstand der Erfindung ist die Anwendung pyrochlorer Gitterstrukturen (mit Gitterparameter *a, 9,8Å<a<10,8Å*) als Pufferschichtsystem für YBCO-Bandleiter. Pyrochlore der Strukturformel $A_2B_2O_7$, wobei A aus der Gruppe des Ca und/oder Nb und/oder der Seltenerdenelementen und B aus der Gruppe des Sm und/oder Hf besteht, weisen aufgrund ihrer chemischen und physikalischen Eigenschaften eine ideale Pufferwirkung gegen die Sauerstoffdiffusion auf und bewirken als Gradientenschicht ein ideales biaxiales Wachstum der nachfolgenden YBCO-Schicht.

Als Beispiel sind oxidische Pufferschichten zu nennen, welche aufgrund ihrer orthorombischen Struktur auf einem *(100)*-orientierten Nickelband biaxial texturiert auf der *(h0l)*-Ebene aufwachsen. Hierbei wird die orthorombische Struktur des Perowskit $CaHfO_3$ durch die Dotierung mit beispielsweise Ce und anderen Selten-Erden eingestellt. Die oxidische Pufferschicht der Strukturformel $(A_{1-x}B_x)CO_3$ zeichnet sich durch exzellente Puffereigenschaften wie hohe Texturschärfe, gute Sauerstoffbarrierewirkung und ausgeprägtes, laterales Wachstum aus.

Im Weiteren wird die Erfindung an einem Ausführungsbeispiel näher erläutert.

Beispiel 1

Dabei zeigen:

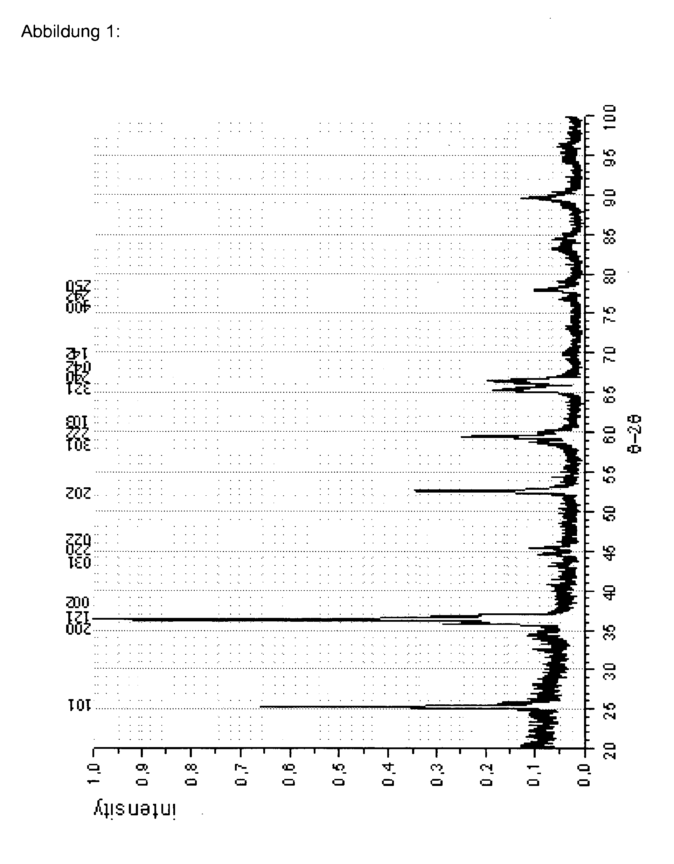

Abbildung 1: $XRD_{(CoK\alpha)}$-Diagramm gemessen am Pulver des $Ca_{1-x}Ce_xHfO_3$ mit x = 0,05

Abbildung 2: $XRD_{(CoK\alpha)}$Diagramm kristallisierter $Ca_{1-x}Ce_xHfO_3$ -Pufferschichten (x = 0,05) auf Ni5%W

Abbildung 3: $XRD_{(CuK\alpha)}$-Diagramm gemessen in der *(111)* - Winkellage des biaxial texturierten *(100)* - Nickels und der *(200)* - Winkellage des epitaktisch gewachsenen *(h0l)* - $Ca_{1-x}Ce_xHfO_3$ mit x = 0,05 in Phirichtung von -25° bis 335°

Abbildung 4: RHEED - Analyse an $Ca_{1-x}Ce_xHfO_3$ mit x = 0,05 Pufferschichten auf biaxial texturierten *(100)*-Nickel

Auf ein texturiertes Nickelband (Ni + 5 at % W) wird $Ca_{1-x}Ce_xHfO_3$ mit x = 0,05 als Pufferschicht aufgebracht.

i) Die Beschichtung erfolgt aus einer Lösung

ii) Für die Lösung wird Ca-hydroxo-methanol-butyrate, Ce-azetat und Hfacetylacetonat in Propionsäure gelöst.

iii) Die Einstellung der Viskosität und damit die Beschichtungseigenschaften werden über die Konzentration (hier 0,3M Lösung) eingestellt.

iv) Die Beschichtung erfolgt auf das texturierte Nickelband mit den Abmessungen 10 x 10 x 0,08 mm³ mittels einer Tauchapparatur. Die Probe wird mit einer Geschwindigkeit von 0,2 cm/s mit einem Winkel von 90° zur Lösungsoberfläche aus der Beschichtungslösung gezogen.

v) Nach der Trocknung unter Luft wird die Probe in dem Ofen unter reduzierender Atmosphäre (Ar/5%$H_2$) temperaturbehandelt.

vi) Die Temperaturbehandlung beinhaltet eine Heizrampe von Raumtemperatur auf 1050°C mit bis 600°C/h und einer Haltezeit von 1 h.

vii) Nach Ablauf der Haltezeit bei Peaktemperatur erfolgt die Ofenabkühlung

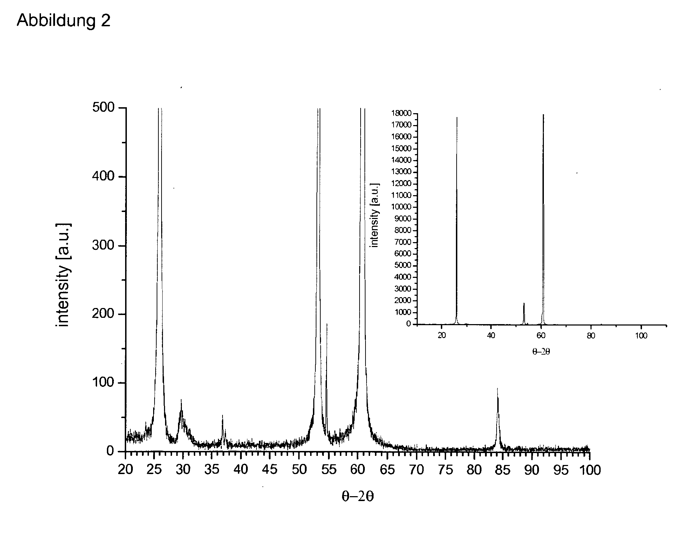

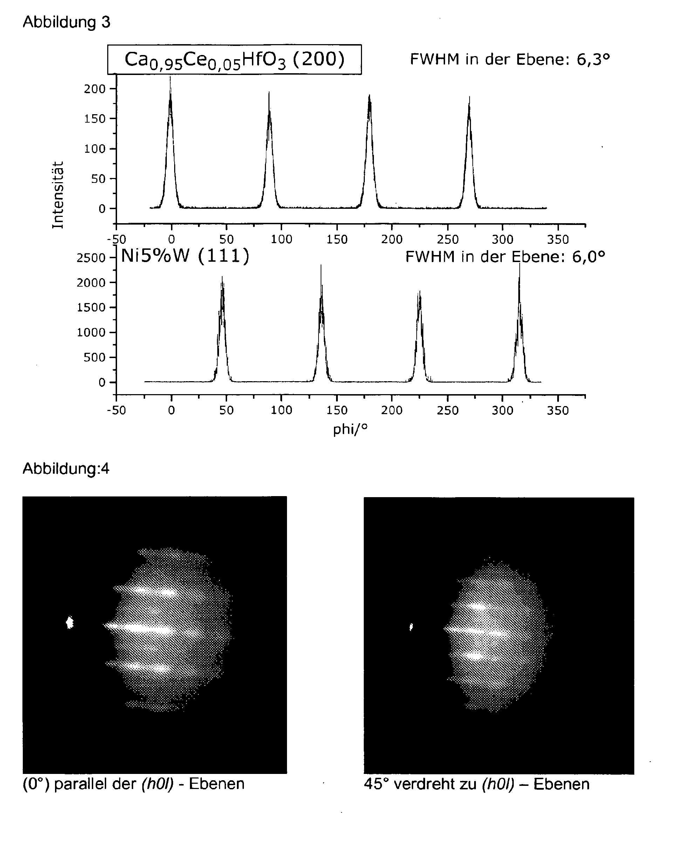

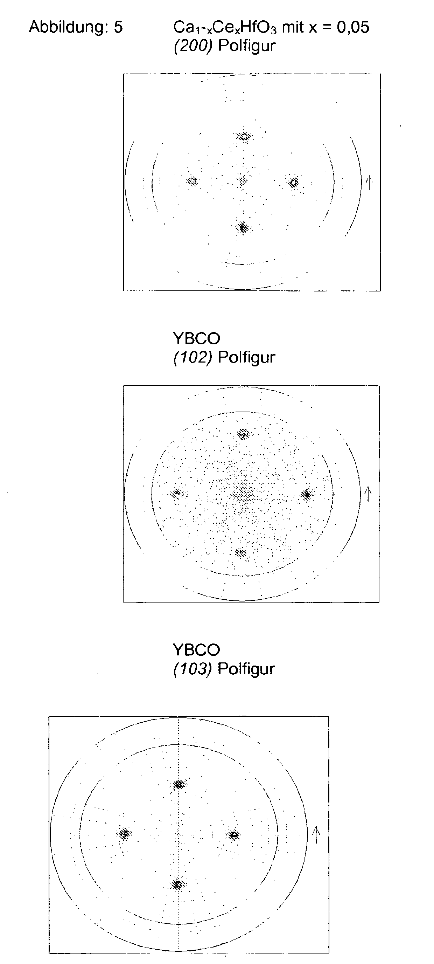

Dabei zeigen die Röntgenbeugungsdiagramme (Abbildung 2 und Abbildung 3), Polfigurmessungen (Abbildung 5) und RHEED-Messungen (Abbildung 4) eine gute Textur.

Nach erfolgter Beschichtung mit dem Hochtemperatursupraleiter YBCO, mittels TFA-Prozess, konnten über induktive Messungen bei 77 K kritische Stromdichten von $J_c$= 1 *$10^6$A*cm$^{-2}$ verzeichnet werden.

Das Pulverdiffraktogramm des $Ca_{1-x}Ce_xHfO_3$ mit x = 0,05 (in Abbbildung:1) dient hierbei als Nachweis über die synthetisierte, orthorombische Kristallstruktur des $Ca_{1-x}Ce_xHfO_3$ mit x = 0,05.

**Patentansprüche**

1. Hochtemperatur-Schichtsupraleiteraufbau, bestehend aus einem biaxial texturierten Substrat, auf dem eine oder mehrere Pufferschichten angeordnet sind und einer oder mehreren darüber angeordneten Supraleiterschichten, wobei mindestens die direkt auf dem Substrat befindliche Pufferschicht mindestens überwiegend aus einem oder mehreren Oxiden mit einem nichtkubischen Kristallgitter besteht, wobei das nichtkubische Kristallgitter mindestens eine quadratische oder quasiquadratische Netzebene aufweist, und diese quadratische oder quasiquadratische Netzebene von mindestens 98 % der nichtkubischen Kristallite der Oxide der Pufferschicht sich auf der dem Substrat zugewandten Seite der Pufferschicht befinden und die quadratischen oder quasiquadratischen Netzebenen der Kristallgitter der Pufferschicht mit einer quadratischen oder quasiquadratischen Netzebene der Kristallgitters des biaxial texturierten Substrates deckungsgleich übereinander oder diagonal zueinander angeordnet sind, wobei die Atomabstände (a) der Netzebene der Kristallgitter der Pufferschicht $a_{Pufferschicht}$ im Vergleich zu denen des Substrats $a_{Substrat}$ die Bedingung

$$1 - \frac{a_{Substrat}}{a_{Pufferschicht} \frac{1}{\sqrt{2}}} \leq \pm 0,1$$ erfüllen.

2. Hochtemperatur-Schichtsupraleiteraufbau nach Anspruch 1, bei dem als biaxial texturiertes Substrat ein Band aus Nickel, Nickel-Wolfram Legierungen, Ni-Chrom Legierungen, Ni-Mangan Legierungen, Ni-Silber Legierung, Kupfer und seine Legierungen, vorteilhafterweise ein (100)-orientiertes Nickelband eingesetzt ist.

3. Hochtemperatur-Schichtsupraleiteraufbau nach Anspruch 1, bei dem als Oxide mit einem nichtkubischen Kristallgitter für die Pufferschicht orthorhombische Perowskite, hexagonale oder tetragonale Kristallstrukturen der Oxide zum Einsatz kommen.

4. Hochtemperatur-Schichtsupraleiteraufbau nach Anspruch 1, bei dem die quadratische oder quasiquadratische Netzebene die (00I)- und/oder die (h0I)- und/oder die (hk0)-Ebene des Kristallgitters der nichtkubischen Oxide ist, vorteilhafterweise Oxide mit einem orthorhombischen Kristallgitter und einer quadratischen oder quasiquadratischen (h0I)-Ebene die Pufferschicht auf dem Substrat bilden und in [001]-Richtung auf dem (100)-orientierten Substrat aufwachsen.

5. Hochtemperatur-Schichtsupraleiteraufbau nach Anspruch 1, bei dem der quasiquadratische Zustand um maximal 5 % vom quadratischen Zustand der Netzebene abweicht.

6. Hochtemperatur-Schichtsupraleiteraufbau nach Anspruch 1, bei dem die direkt auf dem Substrat befindliche Pufferschicht zu 99,8 % aus einem oder mehreren Oxiden mit einem nichtkubischen Kristallgitter bestehen, wobei deren quadratische oder quasiquadratische Netzebene zu 95 bis 100 % auf der Oberfläche angeordnet ist, die sich im direkten Kontakt mit der Substratoberfläche befindet.

7. Hochtemperatur-Schichtsupraleiteraufbau nach Anspruch 1, bei dem 95 % bis alle quadratischen oder quasiquadratischen Netzebenen der nichtkubischen Kristallgitter der Oxide der Pufferschicht deckungsgleich auf den quadratischen oder quasiquadratischen Netzebenen der Kristallgitter der Substratmaterialien angeordnet sind.

8. Verfahren zur Herstellung eines Hochtemperatur-Schichtsupraleiteraufbaus, bei dem auf ein biaxial texturiertes Substrat mindestens ein Oxidmaterial und ein oder mehrere Dotierungselemente gemeinsam ein oder mehrmals nacheinander als eine oder mehrere Pufferschichten aufgebracht und nachfolgend einer Temperaturerhöhung bis maximal 1400°C ausgesetzt werden, wobei mindestens die direkt auf dem Substrat befindliche Pufferschicht ein oder mehrere Oxidmaterialien enthält, wobei als Oxidmaterialien solche Oxide eingesetzt werden, welche in der Lage sind, nach der Temperaturerhöhung bis maximal 1400 °C eine kubische Kristallstruktur auszubilden, und wobei als Oxidmaterial Oxide gemäß der Strukturformel $(A_{1-x}B_x)CO_3$ mit $x \geq 0$, A = Ca, Sr, Ba, Mg, Mn, Mo, Nb, Ru, V, B = Ce, Nd, Sm, Gd, Dy und C= ein Element der IV. Nebengruppe des PSE eingesetzt werden, und wobei die Dotierungselemente die kubische Kristallstruktur des Oxidmaterials während der Temperaturerhöhung in eine nichtkubische Oxidkristallstruktur überführen, und danach mindestens eine supraleitende Schicht aufgebracht und der Schichtverbund wiederum einer Temperaturbehandlung unterzogen wird.

9. Verfahren nach Anspruch 8, bei dem ein (100)-orientiertes Nickelband als Substrat eingesetzt wird.

10. Verfahren nach Anspruch 8, bei dem als Dotierungselemente zur Überführung einer kubischen in eine nichtkubische Oxidkristallstruktur Seltenerden-Elemente oder Mischungen davon eingesetzt werden.

11. Verfahren nach Anspruch 8, bei dem als nichtkubische Oxidkristallstruktur eine orthorhombische Kristallstruktur hergestellt wird.

12. Verfahren nach Anspruch 8, bei dem als quadratische oder quasiquadratische Netzebene die {h0I}-Ebenen des nichtkubischen Oxidkristalles eingestellt wird.

13. Verfahren nach Anspruch 8, bei dem auf ein Substrat mindestens eine Pufferschicht aufgebracht wird, die mittels Abscheidung aus der chemischen Lösung mit nachfolgender Temperaturbehandlung bei 600°C bis 1200°C in reduzierender Atmosphäre synthetisiert wird.

14. Verfahren nach Anspruch 8, bei dem als Oxidmaterial chemische Lösungen eingesetzt werden, welche die Elemente gemäß der Strukturformel $(A_{1-x}B_x)CO_3$ als Precursor-Substanz enthalten, wobei A = Ca, Sr, Ba, Mg, Mn, Mo, Nb, Ru, V und B = Ce, Nd, Sm, Gd, Dy und C = eine Element der IV. Nebengruppe des PSE sind, vorteilhafterweise als Lösungsmittel Karbonsäuren eingesetzt werden, wobei noch vorteilhafterweise als Karbonsäuren Propionsäure, Essigsäure oder Alkohole, sowie Mischungen davon eingesetzt werden, und/oder als Alkohole Methanol, Ethanol, Propanonol, sowie Mischungen davon eingesetzt werden, und/oder vorteilhafterweise als Precursoren metallorganische Verbindungen eingesetzt werden, die noch vorteilhafterweise Azetate, Acetylacetonate, Nitrate, Propoxide, Ethoxide sind.

15. Verfahren nach Anspruch 8, bei dem die Pufferschicht(en) durch Sputtern, gepulster Laserbeschichtung (PLD), Aufdampfen, Ionenstrahl unterstützter Beschichtungsmethoden, Beschichtung aus chemischen Gasphasenreaktionen, Beschichtung mittels Lösungsabscheidung aufgebracht werden.

## Claims

1. High-temperature layer superconductor structure consisting of a biaxially textured substrate, on which one or more buffer layers are arranged, and one or more superconductor layers arranged thereon, wherein at least the buffer layer lying directly on the substrate consists at least predominantly of one or more oxides with a non-cubic crystal lattice, the non-cubic crystal lattice has at least one square or quasi-square network plane, and this square or quasi-square network plane of at least 98% of the non-cubic crystallites of the oxides of the buffer layer lies on the buffer layer's side facing towards the substrate, and the square or quasi-square network planes of the crystal lattices of the buffer layer with a square or quasi-square network plane of the crystal lattice of the biaxially textured substrate are arranged congruently above one another or diagonally with respect to one another, the atomic spacings (a) of the network plane of the crystal lattices of the buffer layer $a_{buffer}$ layer fulfilling the condition

$$1 - \frac{a_{substrate}}{a_{buffer\ layer}\frac{1}{\sqrt{2}}} \leq \pm 0.1$$

in relation to that of the substrate $a_{substrate}$.

2. High-temperature layer superconductor structure according to Claim 1, wherein a strip of nickel, nickel-tungsten alloys, Ni-chromium alloys, Ni-manganese alloys, Ni-silver alloys, copper and its alloys, preferably a (100)-oriented nickel strip, is used as the biaxially textured substrate.

3. High-temperature layer superconductor structure according to Claim 1, wherein orthorhombic perovskites, or hexagonal or tetragonal crystal structures of the oxides are used as the oxides with a non-cubic crystal lattice for the buffer layer.

4. High-temperature layer superconductor structure according to Claim 1, wherein the square or quasi-square network plane is the (001) and/or the (h0l) and/or the (hk0) plane of the crystal lattice of the non-cubic oxides, and oxides with an orthorhombic crystal lattice and a square or quasi-square (h0l) plane preferably form the buffer layer on the substrate and grow in the [001] direction on the (100)-oriented substrate.

5. High-temperature layer superconductor structure according to Claim 1, wherein the quasi-square state differs by at most 5% from the square state of the network plane.

6. High-temperature layer superconductor structure according to Claim 1, wherein 99.8% of the buffer layer lying directly on the substrate consists of one or more oxides with a non-cubic crystal lattice, from 95 to 100% of the square or quasi-square network plane being arranged on the surface which lies in direct contact with the substrate surface.

7. High-temperature layer superconductor structure according to Claim 1, wherein from 95% to all of the square or quasi-square network planes of the non-cubic crystal lattices of the oxides of the buffer layer are arranged congruently on the square or quasi-square network planes of the crystal lattices of the substrate materials.

8. Method for producing a high-temperature layer superconductor structure, wherein at least one oxide material and one or more doping elements are applied jointly once or a number of times in succession with one another as one or more buffer layers onto a biaxially structured substrate, and are subsequently exposed to a temperature increase of at most 1400°C, and at least the buffer layer lying directly on the substrate contains one or more oxide materials, the oxides used as the oxide material being ones which are capable of forming a cubic crystal structure after the temperature increase to at least 1400°C, and oxides according to the structural formula $(A_{1-x}B_x)\ CO_3$ with $x \geq 0$, A = Ca, Sr, Ba, Mg, Mn, Mo, Nb, Ru, V, B = Ce, Nd, Sm, Gd, Dy and C = an element of the IV[th] subgroup of the periodic table are used as the oxide material, and the doping elements convert the cubic crystal structure of the oxide material into a non-cubic oxide crystal structure during the temperature increase, and then at least one superconducting layer is applied and the layer composite is again subjected to a heat treatment.

9. Method according to Claim 8, wherein a (100)-oriented nickel strip is used as the substrate.

10. Method according to Claim 8, wherein rare earth elements or mixtures thereof are used as the doping elements for converting a cubic oxide crystal structure into a non-cubic oxide crystal structure.

11. Method according to Claim 8, wherein an orthorhombic crystal structure is produced as the non-cubic oxide crystal structure.

12. Method according to Claim 8, wherein the {h0l} planes of the non-cubic oxide crystal are set as the square or quasi-square network plane.

**13.** Method according to Claim 8, wherein at least one buffer layer, which is synthesized by deposition from chemical solution with a subsequent heat treatment at from 600°C to 1200°C in a reducing atmosphere, is applied onto a substrate.

**14.** Method according to Claim 8, wherein chemical solutions which contain the elements according to the structural formula $(A_{1-x}B_x)CO_3$ as a precursor substance are used as the oxide material, where A = Ca, Sr, Ba, Mg, Mn, Mo, Nb, Ru, V, B = Ce, Nd, Sm, Gd, Dy and C = an element of the IV[th] subgroup of the periodic table, and carboxylic acids are preferably used as the solvents, propionic acid, acetic acid or alcohols and mixtures thereof more preferably being used as carboxylic acids, and/or methanol, ethanol, propanol and mixtures thereof being used as alcohols, and/or metallorganic compounds are preferably used as precursors, which are more preferably acetates, acetylacetonates, propoxides or ethoxides.

**15.** Method according to Claim 8, wherein the buffer layer(s) are applied by sputtering, pulsed laser deposition (PLD), vapour deposition, ion beam-enhanced deposition methods, deposition from chemical gas phase reactions, or coating by means of solution deposition.

## Revendications

**1.** Structure stratifiée supraconductrice à haute température,
constituée d'un substrat texturé biaxialement sur lequel une ou plusieurs couches tampon sont disposées avant d'être recouvertes par une ou plusieurs couches supraconductrices,
au moins la couche tampon située directement sur le substrat étant constituée au moins principalement d'un ou plusieurs oxydes dont le réseau cristallin n'est pas cubique, le réseau cristallin non cubique présentant au moins un plan réticulaire carré ou quasi carré, ces plans réticulaires carrés ou quasi carrés constitués d'au moins 98 % des cristallites non cubiques des oxydes de la couche tampon étant situés sur le côté de la couche tampon tourné vers le substrat et les plans carrés ou quasi carrés du réseau cristallin de la couche tampon et un plan carré ou quasi carré du réseau cristallin du substrat texturé biaxialement étant disposés l'un au-dessus de l'autre en se recouvrant ou diagonalement l'un par rapport à l'autre,
les distances interatomiques (a) dans le plan réticulaire du réseau cristallin de la couche tampon $a_{Pufferschicht}$ satisfaisant par rapport à celles du substrat $a_{Substrat}$ la relation

$$1 - \frac{a_{Substrat}}{a_{Pufferschicht} \cdot \frac{1}{\sqrt{2}}} \leq \pm 0{,}1 \, .$$

**2.** Structure stratifiée supraconductrice à haute température selon la revendication 1, qui utilise comme substrat texturé biaxialement un ruban de nickel, d'alliages de nickel et de tungstène, d'alliages de nickel et de chrome, d'alliages de nickel et de manganèse, d'un alliage de Ni et d'argent, de cuivre et de ses alliages, et avantageusement un ruban de nickel à orientation (100).

**3.** Structure stratifiée supraconductrice à haute température selon la revendication 1, qui utilise comme oxydes avec un réseau cristallin non cubique pour la couche tampon des perowskites orthorhombiques, des structures cristallins hexagonales ou tétragonales des oxydes.

**4.** Structure stratifiée supraconductrice à haute température selon la revendication 1, dans lequel le plan réticulaire carré ou quasi carré est le plan (001), et/ou le plan (h01), et/ou le plan (hk0) du réseau cristallin des oxydes non cubiques, de préférence des oxydes à réseau cristallin orthorhombique et un plan (h01) ou quasi carré forment la couche tampon sur le substrat et croissent dans la direction [001] sur le substrat à orientation (100).

**5.** Structure stratifiée supraconductrice à haute température selon la revendication 1, dans laquelle l'état quasi carré s'écarte d'au plus 5 % de l'état carré du plan réticulaire.

**6.** Structure stratifiée supraconductrice à haute température selon la revendication 1, dans laquelle la couche tampon située directement sur le substrat est constituée à 99,8 % d'un ou plusieurs oxydes à réseau cristallin non cubique, dont le plan carré ou quasi carré est disposé à 95-100 % sur la surface en contact direct avec la surface du substrat.

**7.** Structure stratifiée supraconductrice à haute température selon la revendication 1, dans lequel de 95 % à tous les plans réticulaires carrés ou quasi carrés du réseau cristallin non cubique et des oxydes de la couche tampon sont disposés en se couvrant mutuellement sur les plans carrés ou quasi carrés du réseau cristallin des matériaux du substrat.

**8.** Procédé de fabrication d'une structure stratifiée supraconductrice à haute température dans lequel au moins un matériau d'oxyde et un ou plusieurs éléments dopants sont appliqués ensemble une fois ou plusieurs fois successivement pour former une ou plusieurs couches tampon sur un substrat texturé biaxialement et sont ensuite exposés à une augmentation de température jusqu'à au plus 1 400°C; au moins la couche tampon en contact direct avec le substrat contenant un ou plusieurs matériaux d'oxyde, les matériaux d'oxyde étant des oxydes en mesure, après l'augmentation de température jusqu'à au plus 1 400°C, de former une structure cristalline cubique, les matériaux d'oxyde utilisés étant des oxydes de formule structurelle $(A_{1-x}B_x)CO_3$ avec $x \geq 0$, A = Ca, Sr, Ba, Mg, Mn, Mo, Nb, Ru, V, B = Ce, Nd, Sm, Gd, Dy et C = un élément du groupe secondaire IV du tableau périodique des éléments, les éléments dopants convertissant la structure cristalline cubique du matériau d'oxyde en une structure cristalline d'oxyde non cubique pendant l'augmentation de température, au moins une couche supraconductrice étant ensuite appliquée et le composite stratifié subissant de nouveau un traitement thermique.

9. Procédé selon la revendication 8, dans lequel on utilise comme substrat un ruban de nickel à orientation (100).

10. Procédé selon la revendication 8, dans lequel on utilise des éléments des terres rares ou leurs mélanges comme éléments dopants pour convertir une structure cristalline d'oxyde cubique en une structure cristalline d'oxyde non cubique.

11. Procédé selon la revendication 8, dans lequel on établit comme structure cristalline d'oxyde non cubique une structure cristalline orthorhombique.

12. Procédé selon la revendication 8, dans lequel on établit comme plan réticulaire carré ou quasi carré les plans {h01} du cristal d'oxyde non cubique.

13. Procédé selon la revendication 8, dans lequel on applique sur un substrat au moins une couche tampon qui est synthétisée par dépôt en solution chimique avec ensuite traitement thermique entre 600°C et 1 200°C dans une atmosphère réductrice.

14. Procédé selon la revendication 8, dans lequel on utilise comme matériau d'oxyde des solutions chimiques qui contiennent des éléments de formule structurelle $(A_{1-x}B_x)CO_3$ comme substances de précurseur, avec A = Ca, Sr, Ba, Mg, Mn, Mo, Nb, Ru, V et B = Ce, Nd, Sm, Gd, Dy et C = un élément du groupe secondaire IV du tableau périodique des éléments, on utilise avantageusement comme solvant des acides carboxyliques et de manière encore plus avantageuse on utilise comme acides carboxyliques l'acide propionique, l'acide acétique ou des alcools ainsi que leurs mélanges et/ou on utilise comme alcools le méthanol, l'éthanol, le propanol ainsi que leurs mélanges et/ou on utilise avantageusement comme précurseurs des composés organométalliques qui sont de manière encore plus avantageuse des acétates, des acétylacétonates, des nitrates, des propoxydes ou des éthoxydes.

15. Procédé selon la revendication 8, dans lequel la ou les couches tampon sont appliquées par pulvérisation, revêtement par laser pulsé (PLD), vaporisation, des procédés de revêtement soutenu par faisceaux d'ions, des revêtements obtenus par des réactions chimiques en phase gazeuse ou un revêtement obtenu au moyen d'un dépôt depuis une solution.

Abbildung 1:

Abbildung 2

Abbildung 3

Ca$_{0,95}$Ce$_{0,05}$HfO$_3$ (200)   FWHM in der Ebene: 6,3°

Intensität

Ni5%W (111)   FWHM in der Ebene: 6,0°

phi/°

Abbildung:4

(0°) parallel der *(h0l)* - Ebenen

45° verdreht zu *(h0l)* – Ebenen

Abbildung: 5    $Ca_{1-x}Ce_xHfO_3$ mit x = 0,05
*(200)* Polfigur

YBCO
*(102)* Polfigur

YBCO
*(103)* Polfigur

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10248025 A1
- US 20020178999 A1
- DE 19932444 C2
- DE 102004041053 A1
- DE 102004038030 A1
- US 20020192508 A1

**In der Beschreibung aufgeführte Nicht-Patentliteratur**

- **T.G. Chirayil.** *Physica C,* 2000, vol. 336, 63-69
- *Physica C,* 2002, vol. 378-381, 1009-1012
- **T. Horide.** *Physica C,* 2004, vol. 412-414, 1291-1295
- **S. Sathyamurthy.** *J. Mater. Res.,* 2004, vol. 19 (7